# FASCICULE DE BREVET EUROPEEN

(11) **EP 4 174 950 B1**
(45) Date de publication et mention de la délivrance du brevet: **28.02.2024**
(21) Numéro de dépôt: 22201835.0
(22) Date de dépôt: 17.10.2022
(51) Int. Cl.: H01L 27/146

(54) **FILTRE PIXELISÉ**
PIXELIERTER FILTER
PIXELATED FILTER

(30) Priorité: 27.10.2021 FR 2111421
(43) Date de publication de la demande: 03.05.2023
(73) Titulaire: COMMISSARIAT À L'ÉNERGIE ATOMIQUE ET AUX ÉNERGIES ALTERNATIVES, 75015 Paris (FR)
(72) Inventeur: VERDET, Sébastien, 38054 GRENOBLE CEDEX 09 (FR); GIROUD-GARAMPON, Cédric, 38054 GRENOBLE CEDEX 09 (FR)
(74) Mandataire: Cabinet Beaumont

(56) Documents cités:
- EP-A1- 3 805 736
- US-A1- 2008 036 023
- US-A1- 2010 308 427

## Description

### Domaine technique

La présente description concerne de façon générale les filtres pixelisés, les procédés de fabrication de ces filtres pixelisés et les dispositifs comprenant de tels filtres pixelisés.

### Technique antérieure

De nombreux dispositifs connus comprennent une pluralité d'éléments photosensibles et une structure ou couche comprenant une pluralité de pixels, chaque pixel comprenant un filtre interférentiel ("interference filter" en anglais). La structure comprenant la pluralité de filtres est appelée filtre pixelisé, et chaque pixel du filtre pixelisé est appelé pixel de filtre, ou plus simplement pixel.

Dans ces dispositifs connus, le filtre pixelisé repose sur la pluralité d'éléments photosensibles, de sorte que chaque élément photosensible soit surmonté d'un pixel du filtre pixelisé, et donc d'un filtre interférentiel. Une ou plusieurs couches peuvent être intercalées entre les éléments photosensibles et le filtre pixelisé et/ou une ou plusieurs couches peuvent reposer sur le filtre pixelisé.

Dans ces dispositifs connus, aussi appelé capteurs de lumière, la lumière incidente reçue par le capteur et destinée à être transmise à un élément photosensible donné doit d'abord traverser le pixel de filtre surmontant cet élément photosensible et, s'il y en a, les couches disposées au-dessus et/ou en-dessous du pixel de filtre, avant d'atteindre cet élément photosensible. Une partie de cette lumière incidente peut atteindre un élément photosensible voisin. Cela résulte en une perte de signal utile de l'élément photosensible qui était destiné à recevoir cette lumière incidente vers ses éléments photosensibles voisins. Ce phénomène est appelé diaphonie. L'augmentation de la diaphonie résulte en une perte de résolution.

La diaphonie est d'autant plus importante que les dimensions et le pas des éléments photosensibles diminuent et/ou que l'épaisseur totale des couches traversées par la lumière incidente avant d'atteindre les éléments photosensibles augmente. A titre d'exemple, l'épaisseur totale des couches traversées par la lumière augmente lorsque le nombre de couches des filtres interférentiels augmente pour améliorer les caractéristiques de filtrage des filtres et/ou la plage d'angle d'incidence de lumière sur laquelle ces filtres ont des caractéristiques de filtrage désirées.

Les documents US 2010/308427 A1 et US 2008/036023 A1 sont pertinents pour la présente invention.

### Résumé de l'invention

Il existe un besoin de pallier tout ou partie des inconvénients des dispositifs connus comprenant un filtre pixelisé.

Un mode de réalisation pallie tout ou partie des inconvénients des filtres pixelisés connus comprenant des pixels de filtre comportant chacun un filtre interférentiel.

Un mode de réalisation prévoit un filtre pixelisé dans lequel chaque pixel du filtre pixelisé comprend un filtre interférentiel comportant un empilement de couches, et plusieurs guides d'onde traversant chacun tout ou partie des couches dudit filtre interférentiel. Dans chaque pixel du filtre pixelisé, les guides d'onde sont configurés pour guider au moins un mode optique et pour qu'une partie évanescente dudit au moins un mode guidé soit filtrée par le filtre interférentiel dudit pixel.

Selon un mode de réalisation, les guides d'onde de chaque deux pixels voisins du filtre pixelisé sont configurés pour que les modes optiques guidés des deux pixels ne se couplent pas les uns avec les autres.

Selon un mode de réalisation, le filtre pixelisé est configuré pour reposer sur une face d'une pluralité d'éléments photo-actifs de sorte que chaque élément photo-actif soit en face d'un pixel du filtre pixelisé.

Selon un mode de réalisation, au moins deux pixels du filtre pixelisé sont différents.

Selon un mode de réalisation, dans chaque pixel du filtre pixelisé, les couches traversées par les guides d'onde sont des couches diélectriques, et chaque guide d'onde est en un ou plusieurs matériaux ayant chacun un indice de réfraction dont la partie réelle est supérieure à la partie réelle de l'indice de réfraction de chacune des couches diélectriques traversées par ledit guide d'onde.

Selon un mode de réalisation, chaque guide d'onde a une section transversale sensiblement constante sur toute sa longueur.

Selon un mode de réalisation, les guides d'onde d'un ou plusieurs pixels du filtre pixelisé ont des longueurs différentes.

Selon un mode de réalisation, dans chaque pixel du filtre pixelisé, les guides d'onde dudit pixel sont en les mêmes matériaux et ont une même section transversale.

Selon un mode de réalisation, dans chaque pixel du filtre pixelisé, les guides d'onde dudit pixel sont organisés en réseau.

Selon un mode de réalisation, dans au moins un des pixels du filtre pixelisé, le réseau de guides d'onde dudit pixel est symétrique par rapport à un axe central dudit pixel et les guides d'onde du réseau ont chacun une même section transversale, symétrique par rapport à un axe longitudinal central dudit guide d'onde.

Un autre mode de réalisation prévoit un dispositif comprenant une pluralité d'éléments photo-actifs et un filtre pixelisé tel que décrit ci-dessus, dans lequel le filtre pixelisé repose sur la pluralité d'éléments photo-actifs de sorte que chaque élément photo-actif soit en vis-à-vis d'un pixel du filtre pixelisé.

Un autre mode de réalisation prévoit un procédé de fabrication d'un filtre pixelisé tel que décrit ci-dessus, comprenant les étapes suivantes :
a) prévoir une structure comprenant, à chaque emplacement d'un pixel du filtre pixelisé, un empilement de tout ou partie des couches d'un filtre interférentiel dudit pixel ;
b) pour chaque pixel du filtre pixelisé, former un masque et plusieurs ouvertures dans ledit masque ;
c) pour chaque pixel du filtre pixelisé, graver une tranchée à partir de chaque ouverture, la tranchée traversant tout ou partie des couches du filtre interférentiel dudit pixel ; et
d) remplir chaque tranchée pour y former un guide d'onde,
dans lequel, dans chaque pixel du filtre pixelisé, les guides d'onde sont configurés pour guider au moins un mode optique et pour qu'une partie évanescente dudit au moins un mode guidé soit filtrée par le filtre interférentiel dudit pixel.

Selon un mode de réalisation, à l'étape a), pour chaque pixel, l'empilement comprend une partie seulement des couches du filtre interférentiel dudit pixel, le procédé comprenant après l'étape d), pour chaque pixel, la formation de l'autre partie des couches du filtre interférentiel dudit pixel.

Un autre mode de réalisation prévoit un procédé de fabrication d'un dispositif comprenant :
- fabriquer, sur un support, un filtre pixelisé en mettant en oeuvre le procédé de fabrication d'un filtre pixelisé décrit ci-dessus ;
- reporter le filtre pixelisé et le support sur une pluralité d'éléments photo-actifs de sorte que chaque élément photo-actif soit en face d'un pixel du filtre pixelisé et que le filtre pixelisé soit intercalé entre la pluralité d'éléments photo-actifs et le support.

Selon un mode de réalisation, le procédé comprend en outre, après l'étape de report :
une étape d'amincissement dudit support, ledit support étant en un matériau transparent aux longueurs d'onde transmises par chacun des filtres interférentiels ; ou
une étape de retrait dudit support.

Un autre mode de réalisation prévoit un procédé de fabrication d'un dispositif comprenant la fabrication, sur une pluralité d'éléments photo-actifs, d'un filtre pixelisé en mettant en oeuvre le procédé de fabrication d'un filtre pixelisé décrit ci-dessus, de sorte que chaque élément photo-actif soit en face d'un pixel du filtre pixelisé.

Selon un mode de réalisation, chacun des procédé de fabrication d'un dispositif décrits ci-dessus comprend en outre, pour chaque pixel du filtre pixelisé, une étape de détermination d'une disposition des guides d'onde dudit pixel les uns par rapport aux autres et des dimensions des sections transversales desdits guides d'onde dudit pixel maximisant une puissance optique d'une partie évanescente d'un super mode optique guidé par les guides d'onde dudit pixel.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue schématique et en coupe d'un exemple de mode de réalisation d'un capteur de lumière ;
la figure 2 est une vue schématique et de dessus d'un filtre pixelisé du capteur de la figure 1 ;
la figure 3 illustre par des courbes des résultats de simulation comparant un pixel de filtre du filtre pixelisé des figures 1 et 2 avec un pixel de filtre de référence ;
la figure 4 illustre par des courbes d'autres résultats de simulation comparant un pixel de filtre du filtre pixelisé des figures 1 et 2 avec un pixel de filtre de référence ;
la figure 5 est une vue schématique et en coupe d'un pixel du filtre pixelisé du capteur des figures 1 et 2 selon une variante de réalisation ;
la figure 6 est une vue schématique et en coupe de deux pixels du filtre pixelisé du capteur des figures 1 et 2 selon une autre variante de réalisation ;
la figure 7 est une vue schématique et en coupe d'un pixel du filtre pixelisé du capteur des figures 1 et 2 selon encore une autre variante de réalisation ;
la figure 8 est une vue schématique et en coupe d'un pixel du filtre pixelisé du capteur des figures 1 et 2 selon encore une autre variante de réalisation ;
la figure 9 est une vue schématique et en coupe d'un pixel du filtre pixelisé du capteur des figures 1 et 2 selon encore une autre variante de réalisation ;
la figure 10 illustre par des vues en coupe un mode de réalisation d'un procédé de fabrication d'un filtre pixelisé ;
la figure 11 illustre par des vues en coupe une variante de réalisation du procédé de la figure 9 ;
la figure 12 illustre par des vues en coupe une variante de réalisation du procédé de la figure 11 ;
la figure 13 illustre par des vues en coupe un autre mode de réalisation d'un procédé de fabrication d'un filtre pixelisé ; et
la figure 14 illustre par une vue en coupe une étape suivante du procédé de la figure 13.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Sauf précision contraire, dans la suite de la description, une première couche repose sur une deuxième couche ou recouvre la deuxième couche signifie soit que la première couche repose directement sur la deuxième couche, ou, dit autrement, que la première couche est disposée sur et en contact avec la deuxième couche, soit que la première couche repose indirectement sur la deuxième couche, ou, dit autrement, qu'une ou plusieurs couches peuvent être intercalées entre les première et deuxième couches.

La présente description propose un filtre pixelisé comprenant une pluralité de pixels de filtre, dans lequel chaque pixel comprend un filtre interférentiel comportant un empilement de couches, et un ou plusieurs guides d'onde traversant chacun tout ou partie des couches du filtre interférentiel. Dans chaque pixel de filtre, le ou les guides d'onde du pixel sont configurés pour guider un ou plusieurs modes optiques et pour qu'une partie évanescente de ces modes guidés soit filtrée par le filtre interférentiel du pixel. Dit autrement, dans chaque pixel de filtre, le ou les guides d'onde sont configurés pour qu'une partie évanescente des modes optiques guidés par ce ou ces guides d'onde interagisse avec les couches du filtre interférentiel que ce ou ces guides d'onde traversent. L'interaction de la partie évanescente des modes guidés avec les couches des filtres interférentiels permet que la lumière guidée par les guides d'onde soit filtrée par les filtres.

Outre le fait que les guides d'onde permettent d'améliorer le guidage de la lumière jusqu'à un élément photosensible correspondant, donc de réduire la diaphonie entre les éléments photosensibles, cela permet d'améliorer la qualité du filtrage pour chaque pixel de filtre, c'est-à-dire, par exemple, d'augmenter la transmission du pixel de filtre dans sa bande passante et/ou la réjection du pixel de filtre hors de sa bande-passante, et/ou d'augmenter l'étendue de la plage d'angle d'incidence de la lumière dans laquelle le pixel de filtre est insensible, ou sensiblement insensible, à l'angle d'incidence de la lumière.

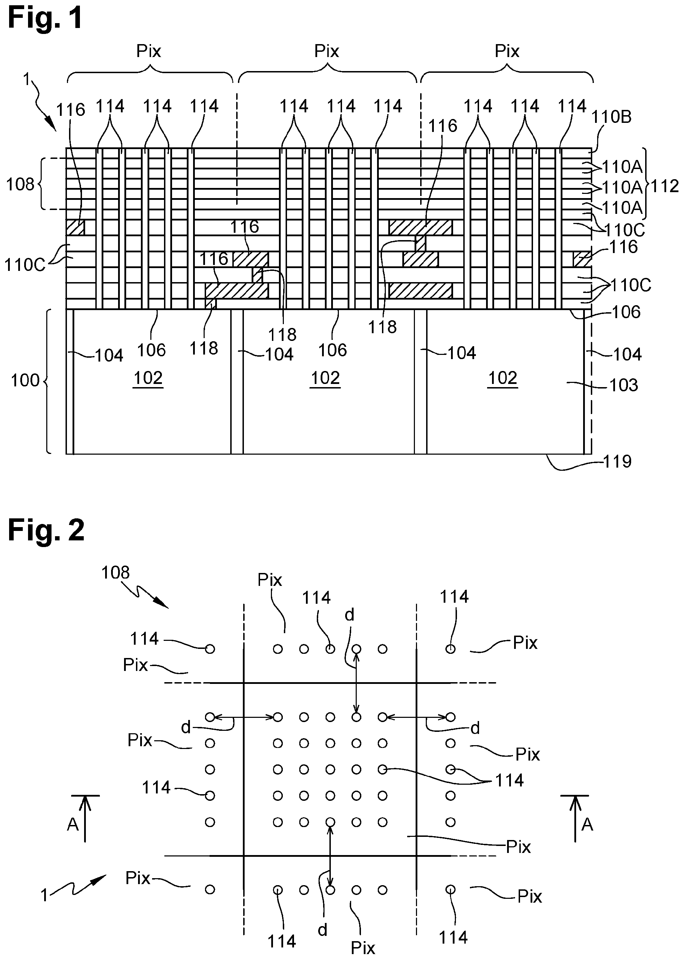

La figure 1 est une vue schématique illustrant un exemple de mode de réalisation d'un capteur de lumière 1. La figure 2 est une vue de dessus d'un exemple de mode de réalisation d'un filtre pixelisé 108 du capteur 1, la figure 1 étant prise dans le plan AA de la figure 2.

Le capteur 1 comprend une pluralité 100 d'éléments photosensibles 102, par exemple disposés en matrice selon des lignes ("row" en anglais) et des colonnes ("column" en anglais) d'éléments photosensibles 102. En figure 1, seul trois éléments photosensibles 102 du capteur 1 sont représentés. En pratique, le capteur 1 comprend par exemple plusieurs centaines ou plusieurs milliers d'éléments photosensibles 102.

Les éléments photosensibles 102 sont formés, c'est-à-dire disposés, dans une couche 103, par exemple un substrat semiconducteur.

A titre d'exemple, chaque élément photosensible 102 est une photodiode formée dans un substrat semiconducteur 103. A titre d'exemple, le substrat 103 est en silicium, et le capteur 1 est configuré pour fonctionner avec de la lumière ayant des longueurs d'onde dans le visible et le proche infra-rouge, par exemple des longueurs d'onde comprises entre 400 et 1000 nm. A titre d'exemple, chaque photodiode 102 est délimitée latéralement par des structures d'isolation verticales 104, par exemple des tranchées d'isolation profondes (DTI de l'anglais "Deep Trench Insulation") ou des tranchées d'isolation profondes capacitives (CDTI de l'anglais "Capacitive DTI"). Les structures 104 isolent électriquement les photodiodes 102 les unes des autres. Les structures 104 peuvent participer à isoler optiquement les photodiodes 102 les unes des autres.

Dans d'autres exemples non illustrés, chaque élément photosensible 102 est un bolomètre ou un photodétecteur à infrarouges en InSb et/ou en HgCdTe (MCT). La personne du métier sera en mesure de prévoir d'autres exemples d'éléments photosensibles 102.

Chaque élément photosensible 102 comprend une face 106 configurée pour recevoir de la lumière. Dans l'exemple de la figure 1, la face 106 de chaque élément photosensible 100 correspond à une partie de la face 106 (face supérieure en figure 1) du substrat 103 comprenant les éléments photosensibles 102.

Le capteur 1 comprend en outre le filtre pixelisé 108. Le filtre pixelisé comprend une pluralité de pixels de filtre Pix. Le filtre pixelisé 108 repose sur la matrice 100 d'éléments 102, c'est-à-dire sur le substrat 103, de sorte que chaque élément photosensible 102 soit surmonté, ou soit en face ou soit revêtu, d'un pixel de filtre Pix. De préférence, chaque élément 102 est surmonté d'un unique pixel Pix, et chaque pixel Pix repose sur un unique élément photosensible 102.

Chaque pixel Pix comprend un empilement de couches 110A dans lequel est défini un filtre interférentiel 112. Dit autrement, chaque pixel Pix comprend un empilement de couches 110A dont au moins certaines forment le filtre interférentiel 112. Dans l'exemple de la figure 1, chaque pixel de filtre Pix ne comprend que les couches 110A de son filtre 112, ou, dit autrement, ne comprend que son filtre 112.

Les couches 110A de chaque filtre 112 sont empilées les unes sur les autres, en contact deux à deux. Dans l'exemple de la figure 1, chaque filtre 112 est un filtre interférométrique, et les couches 110A de chaque filtre 112 sont des couches diélectriques. A titre d'exemple, les couches 110A de chaque filtre 112 comprennent des couches 110A en un premier matériau diélectrique et des couches 110A en un deuxième matériau diélectrique, les couches du premier matériau étant alternées avec les couches du deuxième matériau.

Dans l'exemple de la figure 1, chaque filtre 112 comprend les mêmes couches 110A, ou, dit autrement, les filtres 112 des pixels Pix sont tous identiques.

A titre d'exemple, le filtre 112 de chaque pixel Pix est un filtre passe-bas configuré pour bloquer la lumière infra-rouge, c'est-à-dire, par exemple, la lumière ayant des longueurs d'onde supérieures à 900 nm. Toutefois, dans d'autres exemples, le filtre 112 peut être un filtre passe-bande configuré pour laisser passer de la lumière visible bleu, rouge ou verte uniquement, ou tout autre type de filtre interférométrique.

Chaque pixel Pix comprend au moins un guide d'onde 114, et, plus particulièrement, plusieurs guides d'onde 114 dans l'exemple des figures 1 et 2.

Par exemple, comme cela est illustré par la figure 2, chaque pixel Pix comprend vingt-cinq guides d'onde 114. Pour ne pas surcharger la figure 2, un seul pixel Pix du filtre 108 est entièrement représenté en figure 2, et, un seul guide d'onde 114 par pixel Pix est référencé en figure 2.

Dans l'exemple illustré par la figure 2, les guides d'onde 114 de chaque pixel Pix sont organisés selon un réseau matriciel, c'est-à-dire un réseau de lignes et de colonnes de guides d'onde 114.

Dans d'autres exemples non illustrés, les guides d'onde 114 du pixel Pix forment un réseau dans lequel les guides d'onde 114 sont disposés les uns par rapport aux autres en triangle ou en quinconce. Dans encore d'autres exemples non illustrés, les guides d'onde 114 du pixel Pix ne sont pas organisés en réseau.

A titre d'exemple, l'organisation ou disposition des guides d'onde 114 les uns par rapport aux autres est la même dans chaque pixel Pix du filtre pixelisé 108. Dans d'autres exemples, cette organisation peut être différente entre deux pixels Pix.

Dans chaque pixel Pix, chaque guide d'onde 114 du pixel Pix traverse tout ou partie, c'est-à-dire au moins certaines, des couches 110A du filtre 112 du pixel Pix. De préférence, dans chaque pixel Pix, chaque guide d'onde 114 traverse toutes les couches diélectriques 110A du filtre 112 du pixel Pix.

Il est ici considéré qu'un guide d'onde 114 traverse une couche, par exemple, lorsqu'il traverse la couche sur toute son épaisseur, de manière sensiblement orthogonale à la couche. Ainsi, comme les couches 110A s'étendent chacune de manière sensiblement parallèle à la face 106, les guides d'onde 114 s'étendent longitudinalement dans une direction orthogonale à la face 106.

Dans chaque pixel Pix du filtre pixelisé 108, le ou les guides d'onde 114 sont configurés pour guider un ou plusieurs modes optiques et pour qu'une partie évanescente de ces modes guidés soit filtrée par le filtre interférentiel 112 du pixel Pix.

Le filtre pixelisé 108 peut être revêtu d'une ou plusieurs couches diélectriques 110B, par exemple d'une seule couche diélectrique 110B comme cela est représenté en figure 1. La ou les couches 110B sont par exemple des couches anti-reflet et/ou des couches de passivation.

Selon un mode de réalisation où le filtre pixelisé 108 est revêtu d'une ou plusieurs couches 110B, les guides d'onde 114 peuvent se prolonger à travers toute ou partie de ces couches 110B, ou, dit autrement, peuvent traverser au moins certaines de ces couches 110B. Par exemple, en figure 1, les guides d'onde 114 traversent toutes les couches 110B.

Selon une variante de réalisation non illustrée où le filtre pixelisé 108 est revêtu d'une ou plusieurs couches 110B, les guides d'onde 114 ne traversent aucune couche 110B.

Le filtre pixelisé 108 peut reposer sur une couche diélectrique 110C ou un empilement de couches diélectriques 110C comme cela est représenté en figure 1. Ces couches 110C comprennent par exemple des couches anti-reflet et/ou des couches de passivation.

Lorsque le filtre pixelisé 108 repose sur des couches 110C, une structure d'interconnexion peut être noyée dans les couches 110C comme cela est représenté en figure 1, le capteur est alors dit à éclairement par la face avant (FSI de l'anglais "Front Side Illumination"). A titre d'exemple, la structure d'interconnexion comprend des portions de couches conductrices 116 isolées les unes des autres par des couches 110C et connectés électriquement les unes aux autres par des vias conducteurs traversant des couches 110C.

Selon un mode de réalisation où le filtre pixelisé 108 repose sur une ou plusieurs couches 110C, les guides d'onde 114 peuvent se prolonger à travers toute ou partie de ces couches 110C, ou, dit autrement, peuvent traverser au moins certaines de ces couches 110C. Par exemple, les guides d'onde 114 traversent toutes les couches 110C jusqu'à la face 106 de la couche 103 comprenant les éléments photosensibles 102.

Selon une variante de réalisation non illustrée où le filtre pixelisé 108 repose sur une ou plusieurs couches 110C, les guides d'onde 114 ne traversent aucune couche 110C.

Dans un mode de réalisation où le filtre 108 repose sur des couches 110C, une structure d'interconnexion 116, 118 est noyées dans les couches 110C, et les guides d'onde 114 traversent au moins certaines des couches 110C, de préférence, les guides d'onde 114 ne traversent pas les portions de couches 116. En outre, de préférence, chaque guide d'onde 114 est disposé suffisamment loin des portions de couches 116, par exemple à une distance supérieure ou égale à un quart de la plus petite longueur d'onde de la lumière guidée par le guide d'onde 114, de sorte que ces portions de couches 116 ne perturbent pas la propagation de la lumière par le guide d'onde.

Selon une variante de réalisation non illustrée, le capteur 1 est dépourvu de couche 110C ou de structure d'interconnexion 116, 118 noyée dans ces couches 110C. La structure d'interconnexion du capteur 1 est alors noyée dans des couches isolantes reposant sur une face 119 du substrat 103, la face 119 étant opposée à la face 106. Un tel capteur 1 est dit à éclairement par la face arrière (BSI de l'anglais "Back Side Illumination").

Selon un mode de réalisation, dans chaque pixel Pix, chaque guide d'onde 114 est en un ou plusieurs matériaux ayant chacun un indice optique dont la partie réelle est supérieure ou égale, de préférence strictement supérieure, à la partie réelle de l'indice optique du matériau de chacune des couches 110A, 110B, 110C que traverse ce guide d'onde 114. Dans chaque pixel Pix, un ou plusieurs modes optiques ou un ou plusieurs super modes optiques sont alors guidés par les guides d'onde 114 du pixel Pix. En outre, une partie évanescente de ces modes guidés se retrouve alors dans les couches 110A traversées par les guides d'onde 114 et interagit avec ces couches 110A, d'où il résulte que la partie évanescente des modes guidés, et, plus généralement, les modes guidés eux-mêmes, sont filtrés par le filtre 112 du pixel Pix.

Selon un mode de réalisation, pour chaque pixel Pix, les guides d'onde 114 sont identiques les uns aux autres, c'est-à-dire, par exemple, qu'ils ont la même longueur et ont leurs extrémités disposées aux mêmes niveaux, qu'ils sont en les mêmes matériaux et qu'ils ont les mêmes dimensions. La fabrication de ces guides d'onde est alors plus simple à mettre en oeuvre. Plus particulièrement, dans l'exemple de la figure 1, tous les guides 114 de tous les pixels Pix sont identiques les uns aux autres.

Selon un mode de réalisation, chaque guide d'onde 114 a une section transversale sensiblement constante sur toute sa longueur, c'est-à-dire une section transversale visée constante mais qui, en pratique, peut avoir des dimensions qui varient en raison des procédés de gravure utilisés lors de la fabrication des guides d'onde 114. Des guides d'onde 114 ayant chacun une section transversale sensiblement constante sont plus simples à fabriquer. Dans l'exemple de la figure 1, tous les guides d'onde 114 de tous les pixels Pix ont la même section transversale.

Selon un mode de réalisation, chaque guide d'onde 114 d'un pixel a une section transversale présentant une symétrie de révolution par rapport à un axe parallèle à la direction longitudinale du guide d'onde. A titre d'exemple, la section transversale du guide d'onde 114 a alors la forme d'un disque de contour circulaire. Cette symétrie permet que la propagation de la lumière par chaque guide d'onde 114 d'un pixel soit indépendante de la polarisation de la lumière. De préférence, les guides d'onde 114 du pixel Pix sont alors organisés selon un réseau présentant une symétrie de révolution par rapport à un axe central du pixel Pix, c'est-à-dire un axe parallèle aux guides d'onde 114 passant par le centre du pixel Pix. Ainsi, la propagation du ou des modes optiques guidés par les guides d'onde 114 du pixel Pix est indépendante de la polarisation de la lumière.

Selon un autre mode de réalisation, chaque guide d'onde 114 d'un pixel Pix a une section transversale qui est dépourvue de symétrie de révolution par rapport à un axe parallèle à la direction longitudinale du guide d'onde 114, ce qui permet que la propagation de la lumière guidée par le guide d'onde 114 dépende de la polarisation de la lumière. De préférence, cette dépendance entre la polarisation de la lumière et la façon dont la lumière est guidée dans le pixel Pix par ses guides d'onde 114 est exacerbée en prévoyant que les guides d'onde 114 du pixel Pix ne soient pas disposés de manière symétrique par rapport à un axe central du pixel Pix.

Selon un mode de réalisation, pour chaque deux pixels Pix voisins du filtre pixelisé 108, une distance d (figure 2) entre chaque guide d'onde 114 d'un des deux pixels Pix voisins et chaque guide d'onde 114 de l'autre de ces deux pixels Pix est supérieure ou égale à λmax/nmin, avec λmax la plus grande des longueurs d'onde transmises par les filtres 112 de ces deux pixels Pix voisins et nmin la plus petite des parties réelles des indices optiques des couches diélectriques 110A, 110B et 110C traversées par les guides d'onde 114 de ces deux pixels Pix voisins. Cela permet d'éviter que les modes optiques guidés par les guides d'onde 114 de l'un de ces deux pixels Pix voisins ne se couplent avec les modes optiques guidés par les guides d'onde 114 de l'autre de ces deux pixels Pix voisins, ce qui provoquerait de la diaphonie entre ces deux pixels.

Bien que cela ne soit pas illustré en figures 1 et 2, le capteur 1 peut comprendre des lentilles ou des microlentilles et/ou des filtres couleurs en résine reposant sur le filtre pixelisé 108. Par exemple, au moins un pixel Pix peut être surmonté d'un filtre couleur en résine et/ou d'une microlentille configurée pour focaliser la lumière dans l'élément photosensible 102 sur lequel repose ce pixel Pix.

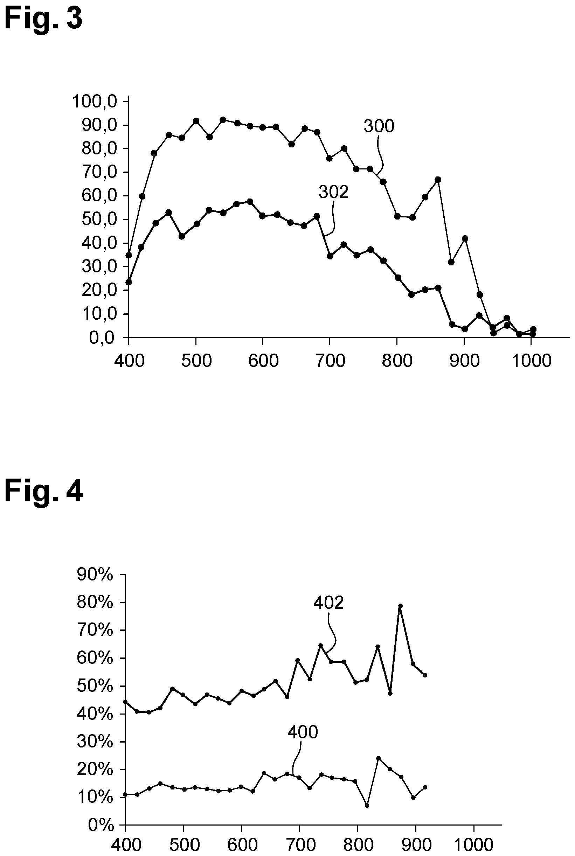

La figure 3 illustre par des courbes 300 et 302 des résultats de simulation comparant un pixel de filtre Pix tel que décrit ci-dessus avec un pixel de filtre de référence. Plus particulièrement, la courbe 300 illustre l'évolution du taux de transmission de la lumière par le pixel Pix (en pourcentage et en ordonnée) en fonction de la longueur d'onde (en abscisse et en nm), la courbe 302 illustrant le taux de transmission de la lumière par le pixel de filtre référence en fonction de la longueur d'onde.

La figure 4 illustre par des courbes 400 et 402 l'évolution de la diaphonie (en pourcentage et en ordonnée) en fonction de la longueur d'onde (en nm et en abscisse), respectivement pour un pixel Pix de la courbe 300 et du pixel de filtre de référence de la courbe 302.

En figure 4, pour évaluer la diaphonie du pixel Pix (courbe 400), quatre pixels Pix identiques sont disposés selon un carré de deux pixels Pix par deux pixels Pix, trois des quatre pixels Pix sont masqués, par exemple par une couche de tungstène, et une microlentille est disposée sur le pixel Pix non masqué. Les quatre pixels Pix sont disposés sur quatre éléments photosensibles 102 (figure 1) correspondant. La diaphonie correspond alors au ratio de la quantité de lumière reçue par les trois éléments photosensibles 102 surmontés des pixels Pix masqués, sur la quantité de lumière totale reçue par les quatre éléments photosensibles 102. La diaphonie pour le pixel de référence (courbe 402) est obtenue de manière similaire, en remplaçant les pixels de filtre Pix par des pixels de filtre de référence.

Les courbes des figures 3 et 4 ont été obtenues par une méthode de calcul de différences finies dans le domaine temporel (FDTD de l'anglais "Finite Différence Time Domain"), dans cet exemple avec un angle d'incidence de la lumière sur les pixels de filtre égal à 10°.

Dans l'exemple des figures 3 et 4, on considère un pixel de filtre Pix dont le filtre 112 est un filtre passe-bas ayant une longueur d'onde de coupure égale à environ 940 nm. Le pixel Pix ne comprend que son filtre 112, ce dernier étant constitué de 32 couches diélectriques 110A en alternant une couche 110A de SiN et une couche 110A de SiO2. Chaque couche 110A a une épaisseur d'environ 100 nm. Les guides d'onde 114 sont en Ta2O5 et traversent toutes les couches 110A du filtre 112. Le pixel Pix a, en vue de dessus, une surface carrée de 1,4 pm de côté. Le pixel Pix comprend 25 guides d'onde 114 de section transversale en forme de disque de 100 nm de diamètre, répartis selon un réseau de 5 lignes et de 5 colonnes avec un pas de 160 nm. Dans cet exemple, le pixel de référence est similaire au pixel Pix à la différence qu'il ne comprend que 16 couches diélectriques et qu'il est dépourvu de guide d'onde 114. Comme le pixel Pix, le pixel de référence est revêtu d'une microlentille.

La figure 3 montre que le pixel Pix de la courbe 300 a une meilleure transmission dans sa bande passante et une meilleure réjection hors de sa bande passante que le pixel de référence de la courbe 302. En particulier, dans la bande passante des filtres 112 des pixels Pix et de référence, par exemple entre 400 et 900 nm, le taux de transmission du pixel Pix est amélioré d'au moins 60 % par rapport à celui du pixel de référence, et, est, par exemple, en moyenne augmenté de 110 % sur cette plage de longueurs d'onde. En outre, le taux de rejection du pixel Pix est augmenté de 260 % à 940 nm par rapport à celui du pixel de référence.

On pourrait s'attendre à ce que l'augmentation du nombre de couches dans le pixel Pix par rapport au pixel de référence entraîne une augmentation de la diaphonie du pixel Pix par rapport au pixel de référence. Toutefois, la figure 4 montre, à l'inverse, que la diaphonie est réduite pour le pixel Pix par rapport à celle du pixel de référence. En particulier, dans l'exemple de la figure 4, la diaphonie du pixel Pix est réduite, sur la plage de longueurs d'onde allant de 400 à 900 nm, d'un facteur 3,75 en moyenne.

En outre, bien que cela ne soit pas illustré par une figure, les inventeurs ont constaté que des résultats similaires à ce qui est décrit ci-dessus en relation avec les figures 3 et 4 sont obtenus pour d'autres angles d'incidences sur les pixels de filtre, par exemple pour des angles d'incidence de 0°, 20° et 30° respectivement.

Ainsi, la prévision des guides d'onde 114 dans les pixels de filtre Pix permet d'augmenter le nombre de couches d'un empilement de couches diélectriques au-dessus d'un élément photosensible 102, sans augmenter ou en diminuant la diaphonie. En particulier, lorsque les couches sont des couches diélectriques 110A d'un filtre interférométrique 112, l'augmentation du nombre de couches 110A du filtre permet d'améliorer ses caractéristiques de filtrage (transmission dans la bande passante, réjection hors bande passante, tolérance angulaire, etc.).

La propagation guidée de la lumière par les guides d'onde 114 réduit l'interaction de la lumière avec les couches 110A du filtre 112 par rapport au cas d'un pixel de référence dépourvu de guide d'onde 114. Toutefois, l'augmentation du nombre de couches 110A permet d'augmenter l'interaction entre la partie évanescente des modes guidés et les couches 110A du filtre 112, et donc de compenser la perte d'interaction entre la lumière et le filtre 112 résultant de la propagation guidée de la lumière par les guides d'onde 114.

Selon un mode de réalisation, on cherche à maximiser l'énergie de la partie évanescente des modes guidés propagés par les guides d'onde 114, pour maximiser l'interaction des modes guidés avec le filtre 112.

Par exemple, pour chaque pixel Pix, il est prévu une étape de détermination d'une disposition des guides d'onde 114 du pixel Pix les uns par rapport aux autres, et des dimensions des sections transversales des guides d'onde 114 du pixel qui maximise une puissance optique d'une partie évanescente d'un super mode optique guidé par les guides d'onde 114 de ce pixel Pix. Dit autrement, il est prévu une étape de détermination d'une disposition des guides d'onde 114 du pixel Pix les uns par rapport aux autres, et des dimensions des sections transversales des guides d'onde 114 du pixel qui maximise un taux de réjection du pixel Pix et/ou un taux de transmission du pixel Pix dans une plage donnée d'angle d'incidence de la lumière sur le pixel Pix. A une longueur d'onde donnée, le taux de transmission, respectivement de rejection, d'un filtre de pixel Pix correspond, par exemple, au pourcentage d'un flux de lumière reçu par une première face du pixel Pix, respectivement qui n'est pas transmis, jusqu'à une deuxième face du pixel Pix, opposée à la première face.

A titre d'exemple, pour chaque pixel Pix, pour que la partie évanescente d'un mode guidé par un guide d'onde 114 interagisse suffisamment avec les couches diélectriques que le guide d'onde 114 traverse, le guide d'onde 114 a une section transversale dont la plus grande dimension dmax (longueur, côté ou diamètre selon le cas) est égale, à plus ou moins 10% près, à Amin/(2*n*Dnmin), avec Amin la plus petite des longueurs d'onde de la bande spectrale d'intérêt, et Dnmin le plus petit écart d'indice optique entre le matériau du guide d'onde 114 et les matériaux diélectriques des couches traversées par le guide d'onde 114.

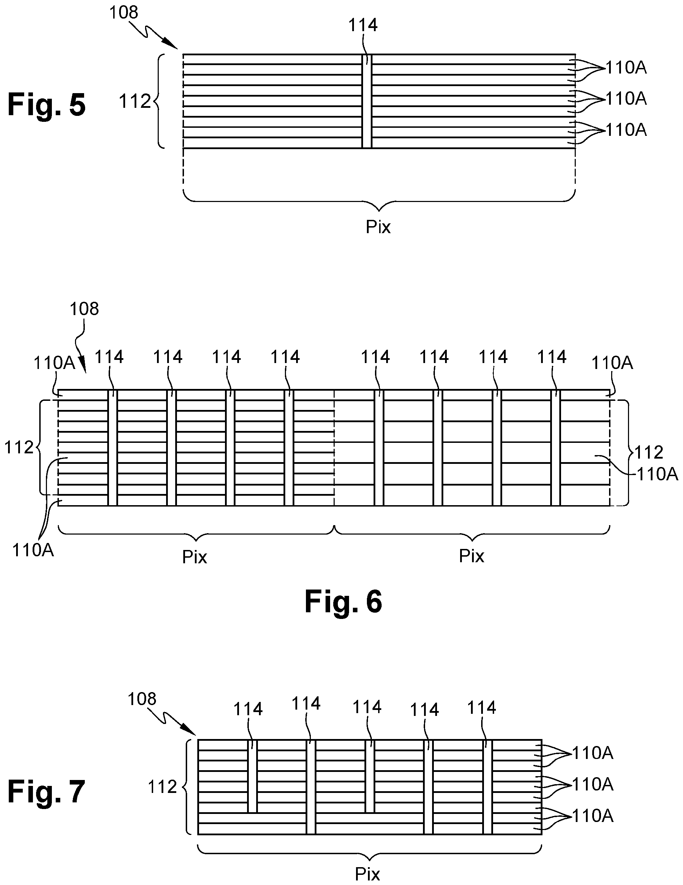

La figure 5 une vue schématique et en coupe d'un pixel Pix du filtre pixelisé 108 selon une variante de réalisation.

Le pixel Pix de la figure 5 diffère de ceux des figures 1 et 2 en ce qu'il ne comprend pas plusieurs guides d'onde 114, mais uniquement un guide d'onde 114. De préférence, cet unique guide d'onde 114 est aligné avec l'axe central du pixel Pix.

L'unique guide d'onde 114 du pixel Pix procure les mêmes avantages que la pluralité de guides d'onde 114 d'un pixel Pix des figures 1 et 2. Toutefois, par rapport à un pixel de filtre de référence dépourvu de guides d'onde, l'augmentation du taux de transmission dans la bande passante du filtre 112 du pixel Pix, l'augmentation du taux de réjection en dehors de la bande passante du filtre 112 et la diminution de la diaphonie sont moins importantes dans le cas du pixel Pix de la figure 5 que dans le cas d'un pixel Pix des figures 1 et 2.

Dans l'exemple de la figure 5, le guide d'onde 114 traverse toutes les couches 110A du pixel Pix. Toutefois, dans d'autres exemples non illustrés, le guide d'onde 114 peut ne traverser que certaines des couches 110A du pixel Pix.

Dans l'exemple de la figure 5, le filtre 112 du pixel Pix comprend toutes les couches 110A de l'empilement de couches 110A du pixel Pix.

La figure 6 est une vue schématique et en coupe de pixels Pix du filtre pixelisé 108 selon une autre variante de réalisation, deux pixels Pix adjacents étant illustrés en figure 6.

Dans cette variante de réalisation, les deux pixels Pix sont différents. Plus particulièrement, les deux pixels Pix ont chacun des filtres 112 différents.

Par exemple, le pixel Pix disposé à droite en figure 6 comprend six couches 110A, et son filtre 112 est constitué de cinq de ces six couches 110A, alors que le pixel Pix disposé à gauche en figure 6 comprend treize couches 110A, et son filtre 112 est constitué de onze de ces treize couches 110A.

Plus généralement, comme cela est illustré par l'exemple de la figure 6, dans chaque pixel Pix, le filtre 112 du pixel Pix peut ne comprendre qu'une partie des couches 110A du pixel Pix. Par exemple, parmi les couches 110A d'un pixel Pix, une partie de ces couches 110A peut constituer le filtre 112 du pixel Pix, et une autre partie de ces couches 110A peut être disposée sur et/sous le filtre 112 du pixel Pix.

Un pixel Pix peut comprendre des couches 110A reposant sur son filtre 112 et/ou des couches 110A sur lesquelles repose ce filtre 112, indépendamment du fait que ce pixel Pix soit différent de son pixel Pix voisin.

Dans l'exemple de la figure 6, dans chaque pixel Pix, les guides d'onde 114 traversent toutes les couches 110A du pixel Pix, et, en particulier, toutes les couches 110A du filtre 112 du pixel Pix. Dans d'autres exemples non illustrés, les guides d'onde 114 peuvent ne traverser qu'une partie des couches 110A du pixel Pix, par exemple uniquement les couches 110A du filtre 112 du pixel Pix ou une partie seulement des couches 110A du filtre 112.

La variante de réalisation illustrée par la figure 6 dans le cas où chaque pixel Pix comprend plusieurs guides d'onde 114 s'applique au cas où au moins un pixel Pix, par exemple chaque pixel Pix, ne comprend qu'un seul guide d'onde 114.

La figure 7 est une vue schématique et en coupe d'un pixel Pix du filtre pixelisé 108 des figures 1 et 2 selon encore une autre variante de réalisation. Dans l'exemple de la figure 7, toutes les couches 110A du pixel Pix appartiennent au filtre 112 du pixel Pix.

Dans cette variante, les guides d'onde 114 du pixel Pix ont des longueurs différentes.

A titre d'exemple, cette variante de réalisation permet d'appliquer une modification du front d'onde de la lumière reçue par le pixel Pix.

Bien que dans l'exemple de la figure 7, tous les guides d'onde 114 du pixel Pix aient leurs sommets au même niveau, dans d'autres exemples les guides d'onde 114 du pixel Pix peuvent avoir des sommets à des niveaux différents.

En outre, dans un autre exemple non illustré, tous les guides d'onde 114 d'un pixel Pix donné ont la même longueur qui est différente de celle d'un ou plusieurs guides d'onde 114 d'autres pixels Pix du filtre 108.

La variante de réalisation décrite en relation avec la figure 7 s'applique aux variantes de réalisation des figures 5 et 6.

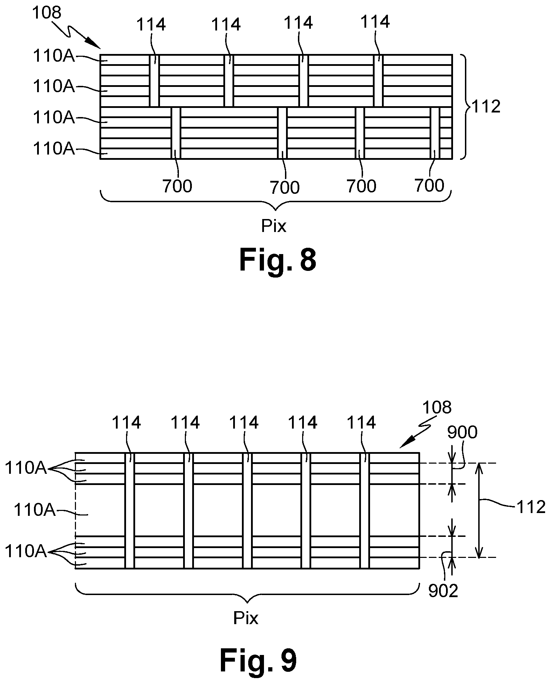

La figure 8 une vue schématique et en coupe d'un pixel Pix du filtre pixelisé 108 des figures 1 et 2 selon encore une autre variante de réalisation. Dans l'exemple de la figure 8, toutes les couches 110A du filtre de pixel Pix appartiennent au filtre 112 du pixel Pix.

Le pixel Pix de la figure 8 diffère des pixels Pix des figures 1 et 2 en ce que ses guides d'onde 114 ne traversent pas toutes les couches 110A du pixel Pix et qu'il comprend au moins un guide d'onde 700 traversant d'autres couches 110A du pixel Pix que celles traversées par les guides d'onde 114.

Par exemple, en figure 8, le pixel Pix comprend des premières couches 110A et des deuxièmes couches 110A, chaque guide d'onde 114 du pixel Pix de la figure 8 ne traverse que des premières couches 110A du pixel Pix et chaque guide d'onde 700 ne traverse que les deuxièmes couches 110A du pixel Pix.

Selon un mode de réalisation, les couches 110A traversées par les guides d'onde 700 sont toutes des couches diélectriques. A titre d'exemple, comme pour les guides d'onde 114, les guides d'onde 700 sont alors en un ou plusieurs matériaux ayant chacun un indice optique dont la partie réelle est supérieure à la partie réelle de l'indice optique du ou des matériaux de chaque deuxième couche 110A traversée par les guides d'onde 700.

Comme cela est représenté en figure 8, les guides d'onde 114 peuvent ne pas être alignés avec les guides d'onde 700.

Dans l'exemple de la figure 8, les guides d'onde 114 s'arrêtent sur la face d'une couche 110A à partir de laquelle débutent les guides d'onde 700.

Dans l'exemple de la figure 8, toutes les couches 110A du pixel Pix sont traversées par un guide d'onde 114 ou par un guide d'onde 700.

Dans un autre exemple, une ou plusieurs couches 110A peuvent être disposées entre les guides d'onde 114 et les guides d'onde 700, c'est-à-dire qu'une ou plusieurs couches 110 peuvent n'être traversées par aucun des guides d'onde 114 et 700 du pixel Pix.

Dans chaque pixel Pix, le nombre de guide d'onde 114 peut être différent du nombre de guides d'onde 700, ou être identique comme cela est illustré en figure 8.

La prévision des guides d'onde 700 en plus des guides d'onde 114 permet, par exemple, de simplifier la fabrication du pixel Pix, du fait que les tranchées à partir desquelles sont formées les guides d'onde respectivement 114 et 700 peuvent être moins profondes que des tranchées à partir desquelles seraient formés des guides d'onde 114 ayant une longueur totale correspondant à la somme de la longueur des guides d'onde 114 du pixel Pix de la figure 8 et de la longueur des guides d'onde 700 de la figure 8.

La prévision des guides d'onde 700 en plus des guides d'onde 114 permet, par exemple, d'adapter les dimensions et le ou les matériaux des guides d'onde 114, respectivement 700, aux matériaux des couches 110A que les guides d'onde 114, respectivement 700, traversent et aux longueurs d'onde que ces guides d'onde sont configurés pour guider, de façon plus fine et moins complexe par rapport aux cas où les couches 110A traversées par les guides d'onde 114 et 700 ne seraient traversées que par des guides d'onde 114 plus longs.

La variante de réalisation décrite en relation avec la figure 8 s'applique aux variantes de réalisation des figures 5, 6 et 7.

La figure 9 est une vue schématique et en coupe d'un pixel Pix du filtre pixelisé 108 des figures 1 et 2 selon encore une autre variante de réalisation. Dans l'exemple de la figure 9, le pixel Pix comprend un filtre 112 correspondant à une cavité de Fabry Pérot plutôt qu'à un filtre interférométrique.

Comme dans le cas d'un filtre 112 interférométrique, lorsque le filtre interférentiel 112 est une cavité de Fabry Pérot, le filtre 112 comprend plusieurs couches 110A de l'empilement de couches 110A du pixel Pix, par exemple toutes les couches 110A du pixel Pix.

Plus particulièrement, le filtre 112 comprend une couche 110A prise en sandwich (ou intercalée) entre une première couche 900 semi-réfléchissante et une deuxième couche 902 semi-réfléchissante.

Selon un mode de réalisation, chacune des couches 900 et 902 correspond à une pluralité de couches 110A diélectriques du pixel Pix. Dans ce cas, les guides d'onde 114 peuvent traverser la couche 900 et/ou la couche 902, par exemple les deux couches 900 et 902 comme cela est illustré en figure 9.

Selon une variante de réalisation, chacune des couches 900 et 902 correspond à une ou plusieurs couches 110A métalliques. Dans ce cas, de préférence, les guides d'onde 114 ne traversent pas les couches 900 et 902, mais uniquement la couche 110A intercalée entre les couches 900 et 902.

Les variantes de réalisation des figures 5, 6, 7 et 8 s'appliquent au cas où le filtre 112 d'un pixel Pix est une cavité Fabry Pérot plutôt qu'un filtre interférométrique.

Plus généralement, le filtre pixelisé 108 peut comprendre deux pixels Pix différents l'un de l'autre du fait que ces pixels Pix comprennent des couches 110A différentes et/ou des guides d'onde 114 différents et/ou des filtres 112 différents.

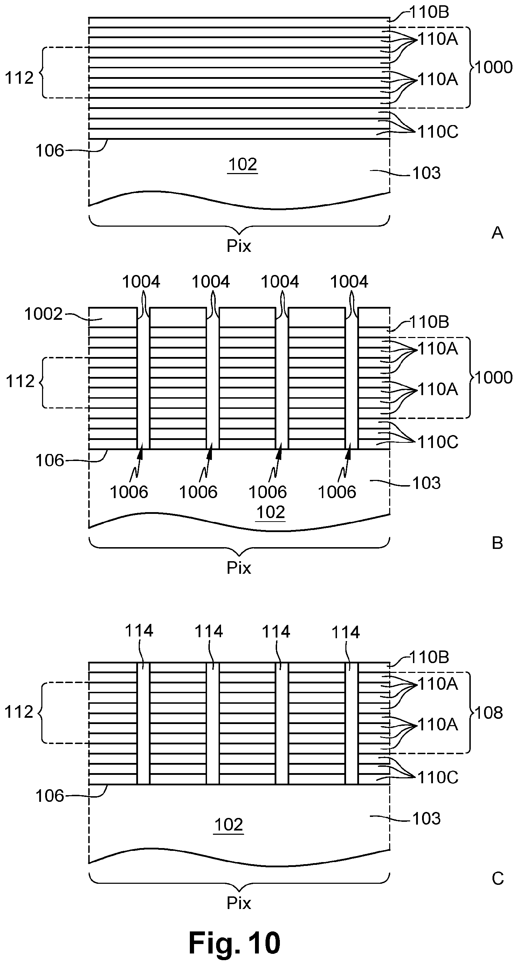

La figure 10 illustre, par des vues A, B et C en coupe, un mode de réalisation d'un procédé de fabrication d'un filtre pixelisé 108.

Bien que l'on illustre ici la fabrication d'un seul pixel Pix du filtre 108, la personne du métier est en mesure d'en déduire comment fabriquer le filtre 108, en mettant en oeuvre les étapes décrites ci-dessous pour chaque pixel Pix du filtre 108, par exemple de manière simultanée pour toute ou partie des pixels Pix du filtre 108.

La figure 10 illustre le cas où le filtre 108 est directement fabriqué sur une pluralité 100 d'éléments photosensibles 102, par exemple sur la face 106 d'un substrat 103 comprenant les éléments photosensibles 102. Dans ce cas, chaque pixel Pix du filtre 108 est fabriqué en vis-à-vis d'un élément 102 correspondant.

La vue A illustre une structure 1000 comprenant, à chaque emplacement d'un pixel Pix du filtre 108, un empilement de couches 110A.

Dans le mode de réalisation de la figure 10, à chaque emplacement de pixel Pix, l'empilement de couches 110A de la structure 1000 comprend toutes les couches 110A du filtre 112 du pixel Pix.

Dans l'exemple de la vue A de la figure 10, l'empilement de couches 110A de chaque emplacement de pixel Pix comprend toutes les couches 110A du pixel Pix.

Dans l'exemple de la vue A de la figure 10, une ou plusieurs couches 110C sont intercalées entre la structure 1000 et la face supérieure 106 de la couche 103 comprenant les éléments 102.

Dans l'exemple de la vue A de la figure 10, une ou plusieurs couches 110B reposent sur la structure 1000.

A l'étape de la vue B de la figure 10, un masque de gravure 1002, de préférence un masque dur, a été formé sur la structure 1000. Dans l'exemple de la figure 10, du fait que des couches 110B reposent sur la structure 1000, le masque 1002 est formé sur et en contact d'une couche 110B. A titre d'exemple, le masque 1002 est en SiO2, en SiN, en Al2O3 ou en TiO2.

Toujours à l'étape de la vue B de la figure 10, pour chaque pixel Pix, une ou plusieurs ouvertures 1004 sont formées à travers le masque 1002. Par exemple, une ouverture 1004 est formée à chaque emplacement d'un guide d'onde 114 du pixel Pix. Chaque ouverture 1004 a une forme, prise dans un plan parallèle à la face 106, qui détermine la forme de la section transversale du guide d'onde 114 qui sera formé à partir de cette ouverture 1004.

Toujours à l'étape de la vue B de la figure 10, pour chaque pixel Pix, une tranchée 1006 est gravée à partir de chaque ouverture 1004. A titre d'exemple, le procédé de gravure mis en oeuvre permet de conserver les dimensions de chaque ouverture 1004 sur toute la longueur de la tranchée 1006 correspondante, c'est-à-dire la tranchée 1006 gravée à partir de cette ouverture 1004.

La gravure des tranchées 1006 est telle que, pour chaque pixel Pix, chaque tranchée 1006 traverse au moins certaines des couches 110A du filtre 112 du pixel Pix. Dans l'exemple de la vue B de la figure 10, les tranchées 1006 sont gravées à travers toutes les couches 110A du filtre 112 de chaque pixel Pix. Plus exactement, dans l'exemple de la vue B de la figure 10, les tranchées 1006 sont gravées à travers toutes les couches 110A de la structure 1000.

Dans l'exemple de la vue B de la figure 10, les tranchées 1006 sont également gravées à travers toutes les couches 110C.

A l'étape de la vue C de la figure 10, les tranchées 1006 de la vue B ont été remplies avec le ou les matériaux constitutifs des guides d'onde 114 de manière à former, dans chaque tranchée 1006, un guide d'onde 114 correspondant.

A titre d'exemple, le dépôt du ou des matériaux constitutifs des guides d'onde 114 est effectué par dépôt de couche atomique (ALD de l'anglais "Atomic Layer Deposition") ou par dépôt de couche atomique amélioré par plasma (PEALD de l'anglais "Plasma Enhanced ALD").

Toujours à l'étape de la vue C de la figure 10, une planarisation mecano-chimique, ou CMP de l'anglais "Chemical-Mechanical Planarization", a été effectuée au moins jusqu'à la couche 1002 pour retirer l'excédent du ou des matériaux des guides d'onde 114 qui a été déposé sur la couche 1002 pour remplir les tranchées 1006.

A titre d'exemple, la CMP est mise en oeuvre de manière à retirer également toute la couche 1002. Dans un autre exemple non illustré, la couche 1002 peut être au moins partiellement laissée en place, et correspondre alors à une couche 110B ou 110A.

La mise en oeuvre des étapes décrites ci-dessus permet de fabriquer un filtre 108 pixelisé directement sur des éléments photosensibles 102, chaque pixel de filtre Pix étant fabriqué en vis-à-vis d'un élément 102 correspondant.

Dans l'exemple de la figure 10, à l'étape de la vue B, les tranchées 1006 traversent toutes les couches 110A du filtre 112. Les guides d'onde 114 formés à l'étape de la vue C traversent donc également toutes ces couches 110A. En outre, à l'étape de la vue B, les tranchées 1006 traversent toutes les couches 110A de la structure 1000, et les guides d'onde 114 formés à l'étape de la vue C traversent donc toutes les couches 110A de la structure 1000.

Dans un autre exemple non illustré, les tranchées 1006 ne sont gravées qu'à travers une partie des couches 110A de la structure 1000, voire à travers une partie seulement des couches 110A du filtre 112. Les guides d'onde 114 formés à l'étape de la vue B ne traversent alors qu'une partie des couches 110A du filtre 108, voire une partie seulement des couches 110A du filtre 112, à savoir les couches 110A traversées par les tranchées 1006.

Dans l'exemple de la figure 10, à l'étape de la vue B, les tranchées 1006 traversent toutes les couches 110C. Les guides d'onde 114 formés à l'étape de la vue C traversent donc toutes les couches 110C.

Dans un autre exemple non illustré, à l'étape de la vue B, les tranchées 1006 ne traversent qu'une partie des couches 110C. Les guides d'onde 114 formés à l'étape de la vue C ne traversent alors qu'une partie des couches 110C, à savoir celles traversées par les tranchées 1006.

Dans encore un autre exemple non illustré, les couches 110C sont omises, la structure 1000, et donc le filtre 108 obtenu à l'étape de la vue C, reposant alors sur et en contact avec les éléments photosensibles 102.

Dans l'exemple de la figure 10, à l'étape de la vue B, les tranchées 1006 traversent des couches 110B. Les guides d'onde 114 formés à l'étape de la vue C traversent donc ces couches 110B.

Dans un autre exemple non illustré, les couches 110B sont omises à l'étape de la vue A.

Par ailleurs, bien que cela ne soit pas illustré en figure 10, une étape supplémentaire optionnelle de formation d'une ou plusieurs couches supplémentaires 110B peut être prévue après la formation des guides d'onde 114. Les guides d'onde 114 ne traversent donc pas ces couches 110B supplémentaires formées après les guides d'onde 114.

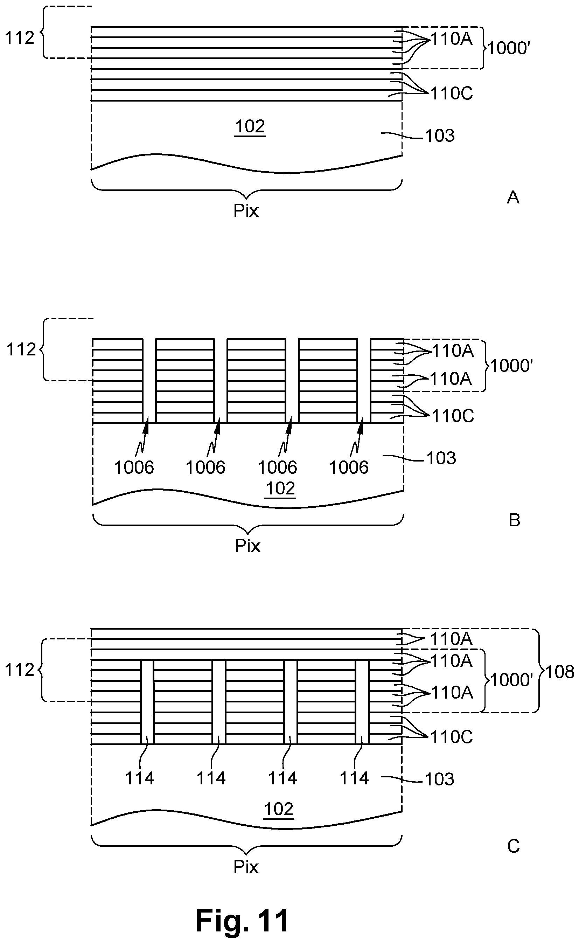

La figure 11 illustre, par des vues A, B et C en coupe, une variante de réalisation du procédé de fabrication de la figure 10.

Bien que l'on illustre ici la fabrication d'un seul pixel Pix du filtre 108, la personne du métier est en mesure d'en déduire comment fabriquer le filtre 108, en mettant en oeuvre les étapes décrites ci-dessous pour chaque pixel Pix du filtre 108, par exemple de manière simultanée pour toute ou partie des pixels Pix du filtre 108.

La figure 11 illustre le cas où le filtre 108 est directement fabriqué sur une pluralité d'éléments photosensibles 102, par exemple sur la face 106 d'un substrat 103 comprenant la pluralité d'éléments photosensibles. Dans ce cas, chaque pixel Pix du filtre 108 est fabriqué en vis-à-vis d'un élément 102 correspondant.

La vue A illustre une structure 1000' comprenant, à chaque emplacement d'un pixel Pix du filtre 108, un empilement de couches 110A.

Dans la variante de mise en oeuvre de la figure 11, à chaque emplacement de pixel Pix, l'empilement de couches 110A de la structure 1000' ne comprend qu'une partie des couches 110A du pixel Pix, par exemple une partie seulement des couches 110A du filtre 112 du pixel Pix.

Dans l'exemple de la vue A de la figure 11, une ou plusieurs couches 110C sont intercalées entre la structure 1000' et la face supérieure 106 des éléments 102.

A l'étape de la vue B de la figure 11, similaire à celle de la vue B de la figure 10, un masque de gravure 1002 (non représenté en figure 11) a été formé sur la structure 1000' et, pour chaque pixel Pix, une ou plusieurs ouvertures 1004 (non représentées en figure 11) ont été formées à travers le masque 1002 puis une tranchée 1006 a été gravée à partir de chaque ouverture 1004.

Dans l'exemple de la vue B de la figure 11, les tranchées 1006 sont gravées à travers toutes les couches 110A de la structure 1000'.

Dans l'exemple de la vue B de la figure 11, les tranchées 1006 sont également gravées à travers toutes les couches 110C.

A l'étape de la vue C de la figure 11, similaire à l'étape de la vue C de la figure 10, les guides d'onde 114 sont formés en remplissant les tranchées 1006 et une CMP est effectuée pour retirer tout ou partie du masque 1002, par exemple pour retirer entièrement le masque 1002 dans l'exemple de la figure 11.

En outre, toujours à l'étape de la vue C de la figure 11, après la formation des guides d'onde 114, la ou les couches 110A du filtre 108 qui ne faisaient pas partie de la structure 1000', c'est à dire qui étaient absentes à l'étape de la vue A de la figure 11, ont été formées sur la structure 1000' munie des guides d'onde 114. Ainsi, dans cette variante, les guides d'onde ne traversent pas toutes les couches 110A de chaque pixel Pix, par exemple ne traversent pas toutes les couches 110A du filtre 112 du pixel Pix.

Comme pour le procédé de la figure 10, bien que cela ne soit pas illustré en figure 11, une étape supplémentaire optionnelle de formation d'une ou plusieurs couches 110B peut être prévue après le dépôt des couches 110A de la vue C de la figure 11.

La mise en oeuvre des étapes décrites ci-dessus permet de fabriquer un filtre 108 pixelisé directement sur des éléments photosensibles 102, chaque pixel de filtre Pix étant fabriqué en vis-à-vis d'un élément 102 correspondant.

Dans l'exemple de la figure 11, à l'étape de la vue B, les tranchées 1006 traversent toutes les couches 110C. Dans un autre exemple non illustré, à l'étape de la vue B, les tranchées 1006 ne traversent qu'une partie des couches 110C. Dans encore un autre exemple, les couches 110C sont omises, la structure 1000', et donc le filtre 108 obtenu à l'étape de la vue C, reposant alors sur et en contact avec les éléments photosensibles 102.

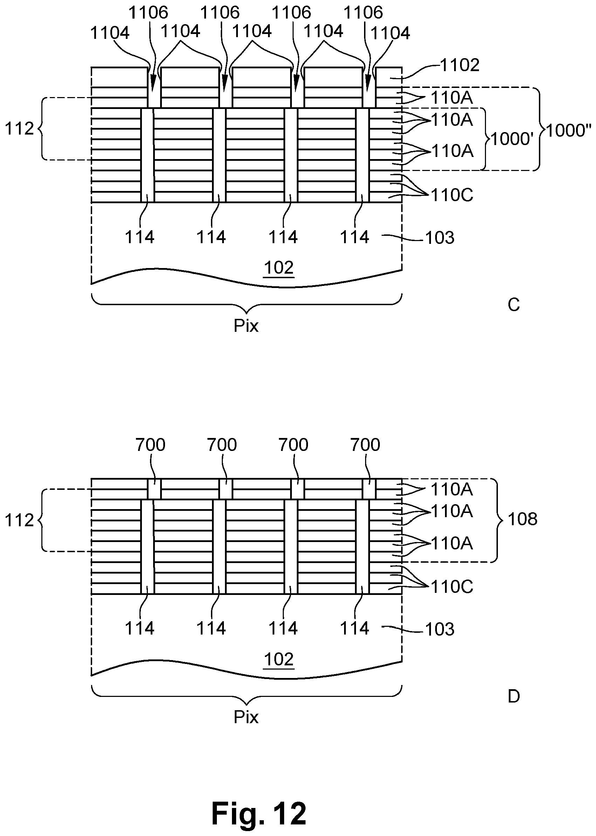

La figure 12 illustre, par des vues en coupe C et D, une variante de mise en oeuvre du procédé de fabrication de la figure 11.

La vue C illustre une étape du procédé suivant l'étape de la vue B de la figure 11, dans le cas où la formation des couches 110A après la formation des guides d'onde 114 conduit à obtenir une structure intermédiaire 1000''. A cette étape, un masque 1102, similaire ou identique au masque 1002, a été formé sur la structure 1000''. Bien que cela ne soit pas le cas en figure 12, avant la formation du masque 1102, une ou plusieurs couches 110B peuvent être formées, de manière similaire à ce qui est représenté par la vue A de la figure 10 où des couches 110B reposent sur la structure 1000 et sous le masque 1002.

Toujours à l'étape de la vue C de la figure 12, de manière similaire à ce qui a été décrit en relation avec la vue B de la figure 10 et avec la vue B de la figure 11, des tranchées 1106 ont été gravées à partir de chaque ouverture 1104. De préférence, la gravure de ces tranchées est arrêtée avant la première couche 110A traversée par les guides d'onde 114.

A l'étape de la vue D de la figure 12, des guides d'onde 700 ont été formés dans les tranchées 1104, de manière similaire à la façon dont les guides d'onde 114 ont été formés dans les tranchées 1004. Comme pour les guides d'onde 114, une CMP est mise en oeuvre après le remplissage des tranchées 1104 pour retirer l'excédent de matériau des guides d'onde 700 qui repose sur le masque 1102, et, de manière optionnelle, tout ou partie du masque 1102.

De manière optionnelle, une ou plusieurs couches 110B peuvent être formées après la formation des guides d'onde 700, par exemple après l'étape de CMP.

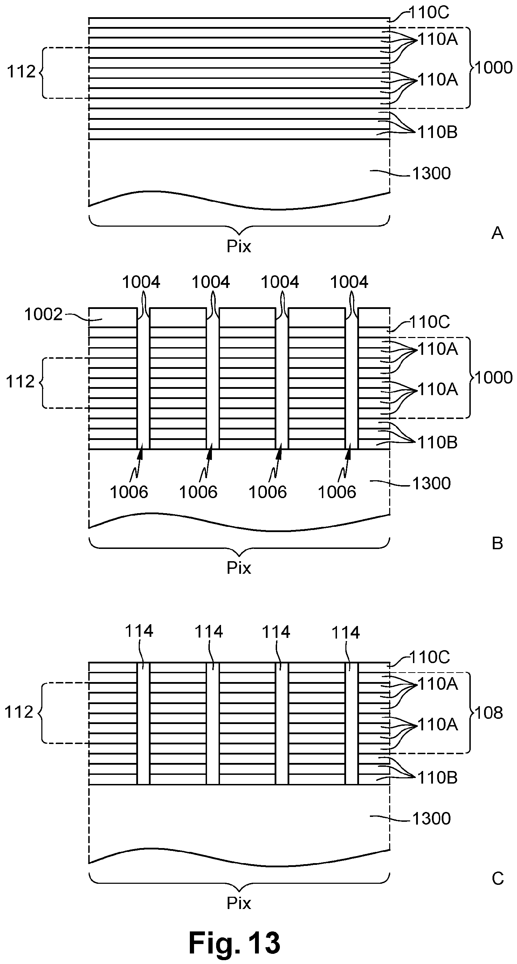

La figure 13 illustre, par des vues A, B et C en coupe, un autre mode de mise en oeuvre d'un procédé de fabrication d'un filtre pixelisé 108. Bien que l'on illustre ici la fabrication d'un seul pixel Pix du filtre 108, la personne du métier est en mesure d'en déduire comment fabriquer le filtre 108, en mettant en oeuvre les étapes décrites ci-dessous pour chaque pixel Pix du filtre 108, par exemple de manière simultanée pour toute ou partie des pixels Pix du filtre 108.

La figure 13 illustre le cas où le filtre 108 est fabriqué sur un support 1300, plutôt que directement sur une couche 103 comprenant les éléments photosensibles 102. Dans ce cas, le filtre 108 fabriqué est configuré pour reposer sur une face 106 des éléments photosensibles 102 de sorte que, lorsque le filtre 108 repose effectivement sur les éléments 102, chaque élément 102 soit en face d'un pixel Pix du filtre pixelisé 108.

Les vues A, B et C de la figure 13 diffèrent des vues respectives A, B et C de la figure 10 en ce que :
la couche 103 comprenant les éléments 102 est remplacée par un support 1300 ; et
la position des couches 110B et 100C est intervertie, c'est à dire que les couches disposées entre le support 1300 et la structure 1000 sont ici référencées 110B plutôt que 110C comme c'était le cas en figure 10, et que les couches reposant sur la structure 1000 sont ici référencées 110C plutôt que 110B comme c'était le cas en figure 10.

Pour le reste, la description faite des vues A, B et C de la figure 10 s'applique aux vues respectives A, B et C de la figure 13, en intervertissant les références 110B et 110C dans cette description. En particulier, les différents exemples de mises en oeuvre décrits en relation avec la figure 10 s'appliquent au procédé de la figure 13, en intervertissant les références 110B et 110C dans la description faite de ces exemples en relation avec la figure 10.

Plus généralement, les exemples de variante de réalisation décrits en relation avec les figures 11 et 12 s'appliquent au cas où les couches 110B et 110C sont interverties et où la pluralité d'éléments 102 est remplacée par un support 1300, en intervertissant les références 110B et 110C dans la description faite précédemment de ces exemples.

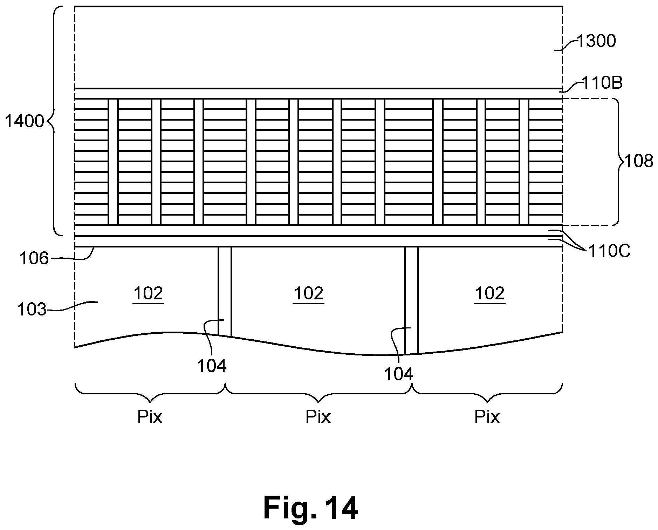

La figure 14 illustre par une vue en coupe une étape suivante d'un procédé de fabrication du filtre 108 sur le support 1300. En figure 14, on appelle 1400 l'ensemble du support 1300 et du filtre 108 obtenu à l'issue d'un des exemples de procédé de fabrication décrits précédemment.

Dans cet exemple, une couche 110B est intercalée entre le support 1300 et le filtre 108. Dans d'autres exemples non illustrés, plusieurs couches 110B sont prévues entre le support 1300 et le filtre 108 ou le filtre 108 peut être directement en contact du support 1300. Dit autrement, selon l'exemple considéré, l'ensemble 1400 peut ou non comprendre une ou plusieurs couches 110B.

A titre d'exemple, en figure 14, la couche 110B est une couche d'arrêt de gravure pour la gravure des tranchées 1006 (voir figure 13).

Dans cet exemple, une couche 110C a été formée sur le filtre 108, du côté opposé au support 1300. Dans d'autres exemples non illustrés, plusieurs couches 110B peuvent être formées sur le filtre 108, ou, à l'inverse, aucune couche 110C n'est formée sur le filtre 108. Dit autrement, selon l'exemple considéré, l'ensemble 1400 peut ou non comprendre une ou plusieurs couches 110C.

A titre d'exemple, en figure 14 la couche 110C est une couche de passivation.

A l'étape de la figure 14, l'ensemble 1400 comprenant le support 1300 et le filtre 108 a été reporté sur une pluralité d'éléments 102, c'est à dire sur une face 106 d'une couche 103 comprenant les éléments 102, de sorte que chaque élément 102 se retrouve en face d'un pixel Pix du filtre 108.

A titre d'exemple, avant l'étape de report, une couche de passivation 110C a été formée sur la face 106 des éléments 102, de sorte que sa mise en contact avec la couche de passivation 110C de l'ensemble 1400 permette un collage moléculaire.

Le support 1300 peut ensuite être aminci, voire supprimé. Bien entendu, dans le cas où toute ou partie du support 1300 est laissé en place sur le filtre 108 après son report sur les éléments 102, le support 1300 est en un matériau transparent aux longueurs d'onde transmises par les pixels Pix.

La personne du métier est en mesure d'adapter les exemples de mode de mise en oeuvre de procédé décrits ci-dessus en relation avec les figures 10 à 14 au cas d'un pixel Pix ne comprenant qu'un seul guide d'onde 114.

En outre, dans les exemples de modes de mise en oeuvre de procédé décrits précédemment, les tranchées 1006 ont toutes la même longueur, d'où il résulte que les guides d'onde 114 qui y sont formés ont tous la même longueur. La personne du métier est en mesure d'adapter ces exemples au cas où les guides d'onde 114 ont des longueurs différentes, par exemple en répétant les étapes de masquage, gravure de tranchée, remplissage des tranchées pour y former des guides d'onde pour chaque longueur différente de guide d'onde 114.

On a décrit ci-dessus des exemples de modes de réalisation et de variantes dans des cas où le dispositif 1 est un capteur de lumière et où les éléments photo-actifs 102 sont des éléments photosensibles configurés pour recevoir de la lumière. La personne du métier est en mesure d'adapter ces exemples de modes de réalisation et de variantes au cas où le dispositif 1 est un dispositif émettant de la lumière, par exemple un micro-écran ("micro-display" en anglais), les éléments 102 étant alors des éléments photoémetteurs configurés pour émettre de la lumière.

En outre, bien que cela ne soit pas revendiqué par la présente demande, la personne du métier est en mesure d'adapter tous les exemples de mode de réalisation décrits aux cas où les guides d'onde 114 traversent toute ou partie des couches d'un empilement de couches, de préférence diélectriques, reposant sur et en vis-à-vis d'un élément photo-actif 102, lorsque cet empilement de couches est dépourvu de filtre interférentiel, les guides permettant alors de réduire la diaphonie entre pixels Pix.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que l'on ait décrit des pixels de filtre Pix comprenant chacun un unique filtre interférentiel 112, la personne du métier est en mesure, à partir de la description faites ci-dessus, de prévoir qu'un ou plusieurs pixels Pix comprennent plusieurs filtres interférentiels.

Enfin, la mise en oeuvre pratique des modes de réalisation et variantes décrits est à la portée de la personne du métier à partir des indications fonctionnelles données ci-dessus. En particulier, la personne du métier est en mesure de déterminer, pour chaque pixel et en fonction de l'application visée :
- les dimensions, le nombre et les matériaux des guides d'onde 114, ;
- le nombre, les matériaux et les épaisseurs des couches 110A de chaque filtre 112 ; et
- la disposition ou répartition des guides d'onde 114. Pour cela, la personne du métier peut, par exemple, se baser sur des résultats de simulations, par exemple des simulations utilisant le calcul FDTD, par exemple des simulations mises en oeuvre au moyen du logiciel désigné par l'appellation commerciale Lumerical.

## Revendications

1. Filtre pixelisé dans lequel :
chaque pixel (Pix) du filtre pixelisé (108) comprend un filtre interférentiel (112) comportant un empilement de couches (11A), et plusieurs guides d'onde (114) traversant chacun tout ou partie des couches (110A) dudit filtre interférentiel (112) ; et
dans chaque pixel (Pix) du filtre pixelisé (108), les guides d'onde sont configurés pour guider au moins un mode optique et pour qu'une partie évanescente dudit au moins un mode guidé soit filtrée par le filtre interférentiel (112) dudit pixel (Pix).

2. Filtre pixelisé selon la revendication 1, dans lequel les guides d'onde (114) de chaque deux pixels voisins (Pix) du filtre pixelisé (108) sont configurés pour que les modes optiques guidés des deux pixels ne se couplent pas les uns avec les autres.

3. Filtre pixelisé selon la revendication 1 ou 2, configuré pour reposer sur une face (106) d'une pluralité d'éléments photo-actifs (102) de sorte que chaque élément photo-actif (102) soit en face d'un pixel (Pix) du filtre pixelisé (108) .

4. Filtre pixelisé selon l'une quelconque des revendications 1 à 3, dans lequel au moins deux pixels (Pix) du filtre pixelisé (108) sont différents.

5. Filtre pixelisé selon l'une quelconque des revendications 1 à 4, dans lequel, dans chaque pixel (Pix) du filtre pixelisé (108), les couches (110A) traversées par les guides d'onde (114) sont des couches diélectriques, et chaque guide d'onde (114) est en un ou plusieurs matériaux ayant chacun un indice de réfraction dont la partie réelle est supérieure à la partie réelle de l'indice de réfraction de chacune des couches diélectriques (110A) traversées par ledit guide d'onde (114).

6. Filtre pixelisé selon l'une quelconque des revendications 1 à 5, dans lequel chaque guide d'onde (114) a une section transversale sensiblement constante sur toute sa longueur.

7. Filtre pixelisé selon l'une quelconque des revendications 1 à 6, dans lequel les guides d'onde d'un ou plusieurs pixels (Pix) du filtre pixelisé (108) ont des longueurs différentes.

8. Filtre pixelisé selon l'une quelconque des revendications 1 à 7, dans lequel, dans chaque pixel (Pix) du filtre pixelisé (108), les guides d'onde (114) dudit pixel sont en les mêmes matériau et ont une même section transversale.

9. Filtre pixelisé selon l'une quelconque des revendications 1 à 8, dans lequel dans chaque pixel (Pix) du filtre pixelisé (108), les guides d'onde (114) dudit pixel (Pix) sont organisés en réseau.

10. Filtre pixelisé selon la revendication 9, dans lequel, dans au moins un des pixels (Pix) du filtre pixelisé, le réseau de guides d'onde (114) dudit pixel (Pix) est symétrique par rapport à un axe central dudit pixel (Pix) et les guides d'onde (114) du réseau ont chacun une même section transversale, symétrique par rapport à un axe longitudinal central dudit guide d'onde (114).

11. Dispositif (1) comprenant :
une pluralité (100) d'éléments photo-actifs (102) ; et
un filtre pixelisé (108) selon l'une quelconque des revendications 1 à 10, dans lequel le filtre pixelisé (108) repose sur la pluralité (100) d'éléments photo-actifs (102) de sorte que chaque élément photo-actif (102) soit en vis-à-vis d'un pixel (Pix) du filtre pixelisé (108).

12. Procédé de fabrication d'un filtre pixelisé selon la revendication 1 comprenant les étapes suivantes :
a) prévoir une structure (1000 ; 1000') comprenant, à chaque emplacement d'un pixel (Pix) du filtre pixelisé (108), un empilement de tout ou partie des couches (110A) d'un filtre interférentiel (112) dudit pixel (Pix) ;
b) pour chaque pixel (Pix) du filtre pixelisé (108), former un masque (1002) et plusieurs ouvertures (1004) dans ledit masque (1002) ;
c) pour chaque pixel (Pix) du filtre pixelisé (108), graver une tranchée (1006) à partir de chaque ouverture (1104), la tranchée (1006) traversant tout ou partie des couches (110A) du filtre interférentiel (112) dudit pixel (Pix) ; et
d) remplir chaque tranchée (1006) pour y former un guide d'onde (114),
dans lequel, dans chaque pixel (Pix) du filtre pixelisé (108), les guides d'onde (114) sont configurés pour guider au moins un mode optique et pour qu'une partie évanescente dudit au moins un mode guidé soit filtrée par le filtre interférentiel (112) dudit pixel (Pix).

13. Procédé selon la revendication 12, dans lequel, à l'étape a), pour chaque pixel (Pix), l'empilement comprend une partie seulement des couches (110A) du filtre interférentiel (112) dudit pixel (Pix), le procédé comprenant après l'étape d), pour chaque pixel (Pix), la formation de l'autre partie des couches (110A) du filtre interférentiel (112) dudit pixel (Pix).

14. Procédé de fabrication d'un dispositif (1) comprenant :
- fabriquer, sur un support (1300), un filtre pixelisé (108) en mettant en oeuvre le procédé selon la revendication 12 ou 13 ;
- reporter le filtre pixelisé (108) et le support (1300) sur une pluralité d'éléments photo-actifs (102) de sorte que chaque élément photo-actif soit en face d'un pixel (Pix) du filtre pixelisé (108) et que le filtre pixelisé (108) soit intercalé entre la pluralité d'éléments photo-actifs (102) et le support (1300).

15. Procédé selon la revendication 14, comprenant en outre, après l'étape de report :
une étape d'amincissement dudit support (1300), ledit support (1300) étant en un matériau transparent aux longueurs d'onde transmises par chacun des filtres interférentiels (112) ; ou
une étape de retrait dudit support (1300).

16. Procédé de fabrication d'un dispositif comprenant la fabrication, sur une pluralité d'éléments photo-actifs (102), d'un filtre pixelisé (108) en mettant en oeuvre le procédé selon la revendication 12 ou 13, de sorte que chaque élément photo-actif (102) soit en face d'un pixel (Pix) du filtre pixelisé (108).

17. Procédé selon l'une quelconque des revendications 12 à 16, comprenant en outre, pour chaque pixel (Pix) du filtre pixelisé (108), une étape de détermination d'une disposition des guides d'onde (114) dudit pixel les uns par rapport aux autres et des dimensions des sections transversales desdits guides d'onde (114) dudit pixel (Pix) maximisant une puissance optique d'une partie évanescente d'un super mode optique guidé par les guides d'onde (114) dudit pixel (Pix).

## Patentansprüche

1. Pixelfilter, wobei:
jedes Pixel (Pix) des Pixelfilters (108) ein Interferenzfilter (112) aufweist, das einen Stapel von Schichten (11A) aufweist, und eine Vielzahl von Wellenleitern (114) aufweist, die jeweils alle oder einen Teil der Schichten (110A) des Interferenzfilters (112) kreuzen; und
in jedem Pixel (Pix) des Pixelfilters (108) der/die Wellenleiter eingerichtet ist/sind wenigstens einen optischen Modus zu führen und so eingerichtet ist/sind, dass ein abklingender Bereich des wenigstens einen geführten Modus durch das Interferenzfilter (112) des Pixels (Pix) gefiltert wird.

2. Pixelfilter nach Anspruch 1, wobei die Wellenleiter (114) eines jeden von zwei benachbarten Pixeln (Pix) des Pixelfilters (108) eingerichtet sind, so dass die geführten optischen Modi der zwei Pixel nicht miteinander koppeln.

3. Pixelfilter nach Anspruch 1 oder 2, das eingerichtet ist, auf einer Oberfläche (106) einer Vielzahl von fotoaktiven Elementen (102) zu ruhen, so dass sich jedes fotoaktive Element (102) vor einem Pixel (Pix) des Pixelfilters (108) befindet.

4. Pixelfilter nach einem der Ansprüche 1 bis 3, wobei wenigstens zwei Pixel (Pix) des Pixelfilters (108) verschieden sind.

5. Pixelfilter nach einem der Ansprüche 1 bis 4, wobei in jedem Pixel (Pix) des Pixelfilters (108) die Schichten (110A), die von dem/den Wellenleitern (114) gekreuzt werden, dielektrische Schichten sind, und wobei jeder Wellenleiter (114) aus einem oder einer Vielzahl von Materialien gefertigt ist, die jeweils einen Brechungsindex haben dessen Realteil größer ist als der Realteil des Brechungsindex jeder der dielektrischen Schichten (110A), die von dem Wellenleiter (114) gekreuzt werden.

6. Pixelfilter nach einem der Ansprüche 1 bis 5, wobei jeder Wellenleiter (114) einen im Wesentlichen konstanten Querschnitt entlang seiner gesamten Länge hat.

7. Pixelfilter nach einem der Ansprüche 1 bis 6, wobei die Wellenleiter von einem oder einer Vielzahl von Pixel (Pix) des Pixelfilters (108) verschiedene Längen haben.

8. Pixelfilter nach einem der Ansprüche 1 bis 7, wobei in jedem Pixel (Pix) des Pixelfilters (108) die Wellenleiter (114) des Pixels aus dem gleichen Material gefertigt sind und einen gleichen Querschnitt haben.

9. Pixelfilter nach einem der Ansprüche 1 bis 8, wobei in jedem Pixel (Pix) des Pixelfilters (108) die Wellenleiter (114) des Pixels (Pix) in einem Netzwerk organisiert sind.

10. Pixelfilter nach Anspruch 9, wobei in wenigstens einem Pixel (Pix) des Pixelfilters (108) das Netzwerk von Wellenleitern (114) des Pixels (Pix) symmetrisch ist bezüglich einer zentralen Achse des Pixels (Pix) und wobei die Wellenleiter (114) des Netzwerks jeweils einen gleichen Querschnitt haben, und zwar symmetrisch bezüglich einer zentralen Längsachse des Wellenleiters (114).

11. Vorrichtung (1), die Folgendes aufweist:
eine Vielzahl (100) von fotoaktiven Elementen (102); und
ein Pixelfilter (108) nach einem der Ansprüche 1 bis 10, wobei das Pixelfilter (108) auf der Vielzahl (100) von fotoaktiven Elementen (102) ruht, so dass jedes fotoaktive Element (102) sich vor einem Pixel (Pix) des Pixelfilters (108) befindet.

12. Herstellungsverfahren eines Pixelfilters nach Anspruch 1, das die folgenden Schritte aufweist:
a) Bereitstellen einer Struktur (1000; 1000`), die an jedem Ort eines Pixels (Pix) des Pixelfilters (108) einen Stapel von allen oder einem Teil der Schichten (110A) eines Interferenzfilters (112) des Pixels (Pix) aufweist;
b) für jedes Pixel (Pix) des Pixelfilters (108) Bilden einer Maske (1002) und einer Vielzahl von Öffnungen (1004) in der Maske (1002);
c) für jedes Pixel (Pix) des Pixelfilters (108) Ätzen einer Rinne (1006) von jeder Öffnung (1004), wobei die Rinne (1006) alle oder einen Teil der Schichten (110A) des Interferenzfilters (112) des Pixels (Pix) kreuzt; und
d) Füllen jeder Rinne (1006) um darin einen Wellenleiter (114) zu bilden, wobei in jedem Pixel (Pix) des Pixelfilters (108) die Wellenleiter (114) eingerichtet sind wenigstens einen optischen Modus zu führen und so eingerichtet sind, dass ein abklingender Bereich des wenigstens einen geführten Modus durch das Interferenzfilter (112) des Pixels (Pix) gefiltert wird.

13. Verfahren nach Anspruch 12, wobei bei Schritt a), und zwar für jedes Pixel (Pix), der Stapel nur einen Teil der Schichten (110A) des Interferenzfilters (112) des Pixels (Pix) aufweist, wobei das Verfahren nach Schritt (d) für jedes Pixel (Pix) das Bilden des anderen Teils der Schichten (110A) des Interferenzfilters (112) des Pixels (Pix) aufweist.

14. Herstellungsverfahren einer Vorrichtung (1), das Folgendes aufweist:
- Herstellen, und zwar auf einer Stützstruktur (1300), eines Pixelfilters (108) durch Umsetzen des Verfahrens nach Anspruch 12 oder 13;
- Übertragen des Pixelfilters (108) und der Stützstruktur (1300) auf eine Vielzahl von fotoaktiven Elementen (102), so dass jedes fotoaktive Element (102) sich vor einem Pixel (Pix) des Pixelfilters (108) befindet und, dass das Pixelfilter (108) zwischen der Vielzahl von fotoaktiven Elementen (102) und der Stützstruktur (1300) eingefügt ist.

15. Verfahren nach Anspruch 14, das ferner nach dem Übertragungsschritt Folgendes aufweist:
einen Schritt des Verdünnens der Stützstruktur (1300), wobei die Stützstruktur (1300) aus einem Material gefertigt ist, das transparent für die Wellenlängen ist, die von jedem der Interferenzfilter (112) übertragen werden; oder
einen Schritt des Entfernens der Stützstruktur (1300).

16. Vorrichtungsherstellungsverfahren, welches das Herstellen eines Pixelfilters (108) auf einer Vielzahl von fotoaktiven Elementen (102) aufweist, und zwar durch Umsetzen des Verfahrens nach Anspruch 12 oder 13, so dass sich jedes fotoaktive Element (102) vor einem Pixel (Pix) des Pixelfilters (108) befindet.

17. Verfahren nach einem der Ansprüche 12 bis 16, das ferner für jedes Pixel (Pix) des Pixelfilters (108) einen Schritt des Bestimmens aufweist, und zwar Bestimmen einer Anordnung der Wellenleiter (114) des Pixels bezüglich zueinander und der Dimensionen der Querschnitte der Wellenleiter (114) des Pixels (Pix) mit Maximierung einer optischen Leistung eines abklingenden Bereichs eines super optischen Modus, der durch die Wellenleiter (114) des Pixels (Pix) geführt wird.

## Claims

1. Pixel filter wherein:
each pixel (Pix) of the pixel filter (108) comprises an interference filter (112) comprising a stack of layers (11A), and a plurality of waveguides (114), each crossing all or part of the layers (110A) of said interference filter (112) ; and
in each pixel (Pix) of the pixel filter (108), the waveguide(s) are configured to guide at least one optical mode and so that an evanescent portion of said at least one guided mode is filtered by the interference filter (112) of said pixel (Pix).

2. Pixel filter according to claim 1, wherein the waveguides (114) of each two neighboring pixels (Pix) of the pixel filter (108) are configured so that the guided optical modes of the two pixels do not couple with one another.

3. Pixel filter according to claim 1 or 2, configured to rest on a surface (106) of a plurality of photoactive elements (102) so that each photoactive element (102) is in front of a pixel (Pix) of the pixel filter (108).

4. Pixel filter according to any of claims 1 to 3, wherein at least two pixels (Pix) of the pixel filter (108) are different.

5. Pixel filter according to any of claims 1 to 4, wherein, in each pixel (Pix) of the pixel filter (108), the layers (110A) crossed by the waveguide(s) (114) are dielectric layers, and each waveguide (114) is made of one or a plurality of materials each having a refraction index having its real part greater than the real part of the refraction index of each of the dielectric layers (110A) crossed by said waveguide (114).

6. Pixel filter according to any of claims 1 to 5, wherein each waveguide (114) has a substantially constant cross-section along its entire length.

7. Pixel filter according to any of claims 1 to 6, wherein the waveguides of one or a plurality of pixels (Pix) of the pixel filter (108) have different lengths.

8. Pixel filter according to any of claims 1 to 7, wherein, in each pixel (Pix) of the pixel filter (108), the waveguides (114) of said pixel are made of the same material and have a same cross-section.

9. Pixel filter according to any of claims 1 to 8, wherein in each pixel (Pix) of the pixel filter (108), the waveguides (114) of said pixel (Pix) are organized in a network.

10. Pixel filter according to claim 9, wherein, in at least one of the pixels (Pix) of the pixel filter, the network of waveguides (114) of said pixel (Pix) is symmetrical with respect to a central axis of said pixel (Pix) and the waveguides (114) of the network each have a same cross-section, symmetrical with respect to a central longitudinal axis of said waveguide (114).

11. Device (1) comprising:
a plurality (100) of photoactive elements (102); and
a pixel filter (108) according to any of claims 1 to 10, wherein the pixel filter (108) rests on the plurality (100) of photoactive elements (102) so that each photoactive element (102) is in front of a pixel (Pix) of the pixel filter (108).

12. Manufacturing method of a pixel filter according to claim 1 comprising the following steps:
a) providing a structure (1000; 1000') comprising, at each location of a pixel (Pix) of the pixel filter (108), a stack of all or part of the layers (110A) of an interference filter (112) of said pixel (Pix);
b) for each pixel (Pix) of the pixel filter (108), forming a mask (1002) and a plurality of openings (1004) in said mask (1002);
c) for each pixel (Pix) of the pixel filter (108), etching a trench (1006) from each opening (1004), the trench (1006) crossing all or part of the layers (110A) of the interference filter (112) of said pixel (Pix); and
d) filling each trench (1006) to form a waveguide (114) therein,
wherein, in each pixel (Pix) of the pixel filter (108), the waveguides (114) are configured to guide at least one optical mode and so that an evanescent portion of said at least one guided mode is filtered by the interference filter (112) of said pixel (Pix).

13. Method according to claim 12, wherein, at step a), for each pixel (Pix), the stack comprises only part of the layers (110A) of the interference filter (112) of said pixel (Pix), the method comprising after step d), for each pixel (Pix), the forming of the other part of the layers (110A) of the interference filter (112) of said pixel (Pix).

14. Method of manufacturing a device (1) comprising:
- manufacturing, on a support (1300), a pixel filter (108) by implementing the method according to claim 12 or 13;
- transferring the pixel filter (108) and the support (1300) onto a plurality of photoactive elements (102) so that each photoactive element (102) is in front of a pixel (Pix) of the pixel filter (108) and that the pixel filter (108) is interposed between the plurality of photoactive elements (102) and the support (1300).

15. Method according to claim 14, further comprising, after the transfer step:
a step of thinning of said support (1300), said support (1300) being made of a material transparent to the wavelengths transmitted by each of the interference filters (112); or
a step of removal of said support (1300).

16. Device manufacturing method comprising the manufacturing, on a plurality of photoactive elements (102), of a pixel filter (108) by implementing the method according to claim 12 or 13, so that each photoactive element (102) is in front of a pixel (Pix) of the pixel filter (108).

17. Method according to any of claims 12 to 16, further comprising, for each pixel (Pix) of the pixel filter (108), a step of determination of an arrangement of the waveguides (114) of said pixel with respect to one another and of the dimensions of the cross-sections of said waveguides (114) of said pixel (Pix) maximizing an optical power of an evanescent portion of a super optical mode guided by the waveguides (114) of said pixel (Pix).
